# EUROPEAN PATENT SPECIFICATION

(11) **EP 4 420 049 B1**
(45) Date of publication and mention of the grant of the patent: **08.10.2025**
(21) Application number: 22806078.6
(22) Date of filing: 20.10.2022
(51) Int. Cl.: G06N 10/40, B82Y 10/00

(54) **TOPOLOGICAL QUBITS, REGISTERS, AND METHODS**
TOPOLOGISCHE QUBITS, REGISTER UND METHODEN
QUBITS, REGISTRES ET MÉTHODES TOPOLOGIQUES

(30) Priority: 20.10.2021 US 202163257956 P
(43) Date of publication of application: 28.08.2024
(73) Proprietor: Streamline Automation, LLC, Hunstville, AL 35805 (US); Wake Forest University, Winston-Salem, NC 27157 (US)
(72) Inventor: REICH, Alton J., Huntsville, AL 35805 (US); CARROLL, David L., Winston-Salem, NC 21104 (US); DI SALVO, Roberto, Cincinnati, OH 45245 (US)
(74) Representative: Invent Horizon IP
(86) International application number: PCT/US2022/047295
(87) International publication number: WO 2023/069632

(56) References cited:
- WO-A2-2018/190919
- US-A1- 2020 098 990
- HÖTGER ALEXANDER ET AL: "Gate-Switchable Arrays of Quantum Light Emitters in Contacted Monolayer MoS 2 van der Waals Heterodevices", NANO LETTERS, vol. 21, no. 2, 12 January 2021 (2021-01-12), US, pages 1040 - 1046, XP093014721, ISSN: 1530-6984, DOI: 10.1021/acs.nanolett.0c04222
- ZHAO HUAN ET AL: "Site-Controlled Telecom Single-Photon Emitters in Atomically-thin MoTe2", RESEARCH SQUARE, 23 July 2021 (2021-07-23), XP093014541, Retrieved from the Internet <URL:https://assets.researchsquare.com/files/rs-452814/v2/b910a12f-f8fa-48af-bab8-765e2ab57fd3.pdf?c=1637395646> [retrieved on 20230117], DOI: 10.21203/rs.3.rs-452814/v2
- KLEIN J. ET AL: "Site-selectively generated photon emitters in monolayer MoS2 via local helium ion irradiation", NATURE COMMUNICATIONS, vol. 10, no. 1, 21 June 2019 (2019-06-21), XP093015204, Retrieved from the Internet <URL:https://www.nature.com/articles/s41467-019-10632-z.pdf> [retrieved on 20230116], DOI: 10.1038/s41467-019-10632-z
- YAQIAN WANG ET AL: "Spin-Valley Locking Effect in Defect States of Monolayer MoS_2", ARXIV.ORG, CORNELL UNIVERSITY LIBRARY, 201 OLIN LIBRARY CORNELL UNIVERSITY ITHACA, NY 14853, 21 February 2020 (2020-02-21), XP081605061

## Description

### BACKGROUND OF THE INVENTION

### Field of the Invention

The present invention relates generally to systems and methods for making quantum computing hardware and to registers comprising topological quantum bits (TQBs) and other components for computational systems. The invention is defined in the appended independent claims 1 and 9. Preferred embodiments of the invention are set out in the appended dependent claims.

### Description of Related Art

In quantum computing, quantum-mechanical phenomena such as superposition and entanglement are used to perform certain types of computations. Quantum computer circuits are based on quantum bits, also called "qubits" or "qbits," which are the fundamental units of information storge, processing, or representation in a quantum computer. A qubit is capable of existing in two states, 0 or 1, simultaneously in a state of superposition or at different times. Multiple qubits are functionally coupled to make a quantum register, which is a quantum analog of a classical processor register. Quantum logic gates (or quantum gates) are basic quantum circuits comprising a small number of qubits that can be combined to make larger quantum computing circuits. Quantum logic gates enable logical operations to be performed using quantum bits to control the flow of information and processing of it within a quantum computer. Patent document US 2020/098990 A1 (NAYFEH OSAMA M [US] ET AL) 26 March 2020 (2020-03-26) discloses a topological quantum register comprising an array of topological qubits on a substrate, wherein each of said topological qubits comprises a topological quantum nanoparticle wherein said topological quantum nanoparticle is a Nd:Nb (Neodymium (Nd) and Niobium (Nb)) nanoplatelet.

To make a qubit stable, it must be protected from outside interferences, such as thermal noise and electromagnetic noise, that can disrupt the quantum state. This usually requires the qubit to be cooled to cryogenic temperatures approaching absolute zero, which is a serious limitation of current quantum computers. The implementation of quantum computing is also limited by short coherence times, or the length of time a prepared or measured quantum state can be maintained, for existing qubits. This is, at least in part, because current quantum computing technology is based on entangling electrons, photons, or ions, which cannot be directly coupled to electronic components.

PCT/US20/56725, describes a qubit device comprising a crystal immobilized on a substrate and in contact with electrodes. The crystal exhibits a charge pair symmetry and with an electron current moving clockwise, counter clockwise, or both. The current can be placed in a state of superposition wherein the current is unknown until it is measured, and the direction of the current is measured to produce a binary output corresponding to a logical zero or a logical one. A state of the qubit device is monitored by measuring a voltage, a current, or a magnetic field and assigning a superposition or base state depending on a threshold value.

Difficulties associated with methods for making topological quantum computing components include proper positioning and orientation of nanoparticles and establishing electrical contacts between the qubits to form registers, logic gates, and other components. Means for measuring the quantum states of topological qubits in a register simultaneously are needed. Methods for positioning of nanoparticles, such as topological insulator nanocrystals, on a substrate are needed for the production of topological quantum computing components. Such methods preferably include forming connections between nanocrystal and electrical leads, selectively placing nanocrystals relative to one another, and/or assessment of proper placement and orientation of the nanocrystals. Currently, topological quantum computer connections are fixed so that a register comprising topological qubits cannot be reconfigured.

### SUMMARY OF THE INVENTION

Embodiments of the present invention preferably seek to mitigate, alleviate or eliminate one or more deficiencies, disadvantages or issues in the art, such as the above identified, singly or in any combination by providing a qubit comprising a topological quantum nanoparticle, a quantum qubit register comprising an array of entangled topological qubits, a quantum computer comprising a quantum qubit register, a method of making a topological qubit register, and a method for simultaneously determining the states of topological quantum qubits in a topological qubit register.

The invention involves topological quantum nanoparticles (TQNs) that exhibit stable superpositions of spin current electron flows that can be entangled between topological quantum nanoparticles at temperatures up to and above room temperature. Topological insulators are materials that do not conduct electricity through them but display topological effects that allow electrons to travel on their surfaces or edges.

TQNs are chiral topological insulator nanoparticles that may be placed on a substrate to make quantum registers and quantum logic gates. Examples of TQNs include chiral transition metal dichalcogenide (TMD) nanoplatelets. Qubits, registers, and logic gates comprised of TQNs are operable at much higher temperatures, are less susceptible to interference, and have longer coherence times than those of existing quantum computing technologies. TMD nanoplatelets and other TQNs may function for quantum computing even when imperfectly formed or damaged. Embodiments of the qubits, registers, and logic gates can have sizes on the micrometer scale, making their manufacture and operation simpler and less expensive than existing qubits, registers, and logic gates. Additionally, the states of the qubits may be measured by means that are less complex and less expensive than those required for exiting quantum computers.

A topological qubit is a qubit comprising a TQN that can have a stable superposition of spin current electron flows around the TQN as well either of two states in which the spin electron currents flow in different directions around the TQN. Topological qubits as described may be used to make quantum registers in which the states of all qubits are read simultaneously. The topological qubits described herein may be used for making quantum gates, including Pauli gates and quantum logic gates, and for making quantum circuits.

### BRIEF DESCRIPTION OF DRAWINGS

The elements of the drawings are not necessarily to scale relative to each other, with emphasis placed instead upon clearly illustrating the principles of the disclosure. Like reference numerals designate corresponding parts throughout the several views of the drawings.
Fig. 1 is a top view transmission electron micrograph of a bipyramidal transition metal dichalcogenide (TMD) nanoplatelet.
Fig. 2 is an illustration of the process of bipyramidal TMD nanoplatelet growth.
Fig. 3 is a top view of a pyramidal TMD nanoplatelet.
Fig. 4 is a side cross-sectional view of a qubit comprising a TQN on a silicon substrate.
Fig. 5 is a side cross-sectional view of a qubit comprising a TQN on a silicon substrate.
Fig. 6 is a top view of a qubit comprising a TQN on a silicon substrate.
Fig. 7 is an example of a current measurement result.
Fig. 8 is a top view of a qubit configured for capacitance measurement.
Fig. 9 is a top view of an alternate qubit configured for capacitance measurement.
Fig. 10 is a top view of an alternate qubit configuration for capacitance measurement.
Fig. 11 is an example of a capacitance measurement result.
Fig. 12 is a top view of an alternate qubit configuration for magnetic measurement.
Fig. 13 is a side view illustrating proximity entanglement between TQNs in a qubit register.
Fig. 14 is a side cross-section view illustrating top to top electrical entanglement.
Fig. 15 is a side cross-section view illustrating top to bottom electrical entanglement.
Fig. 16 is a side cross-section view illustrating bottom to bottom electrical entanglement.
Fig. 17 is a top view illustration of a six qubit register of proximity entangled TQNs.
Fig. 18 is a top view illustration of a four qubit register of electrically entangled TQNs.
Fig. 19 is a top view illustration of a two qubit register of electrically entangled TQNs configured for capacitance measurement.
Fig. 20 is a top view illustration of one embodiment of a qubit register comprising six qubits and seven switches for selectively entangling qubits.
Fig. 21 is a top view illustration of one embodiment of a qubit register comprising eight qubits and fourteen electrical connections with switches for selectively entangling qubits.
Fig. 22 is a schematic showing one embodiment of a method for making a qubit register.
Fig. 23 is a photograph of a four cubit register.
Fig. 24 is a schematic representation of a quantum computer comprising TQNs.

### DETAILED DESCRIPTION OF THE INVENTION

All art specific terms are intended to have their art accepted meaning unless otherwise specified. All non art specific words are intended to have their plain language meanings in the context with which they are used, unless otherwise specified.

As used herein, a nanoparticle is a particle having at least one dimension that is less than 1,000 nanometers, or 1 micrometer, in length. The term "nanoplatelet" is used herein to refer to a nanoparticle having a diameter of from about 0.5 micrometer to about 20 micrometers and a height of less than about 200 nanometers.

As used herein, a "topological quantum nanoparticle" is a nanoparticle comprising a quantum object having a topology that creates at least two degenerate charge parity protected quantum states exhibiting spin current flows.

As used herein, a "topological quantum nanocrystal" is a crystalline nanoparticle comprising a quantum object that uses its topology to create at least two degenerate charge parity protected quantum states and separates the occupation of the states by reducing tunneling/hopping transitions between the states. Examples of a "topological quantum nanocrystal" include chiral, self-assembled, bipyramidal transition metal dichalcogenides comprising MoS₂, Sb₂Te₃, or Bi₂Te₃, optionally decorated with nanoparticles of elements from Group IVA-VIIIA and Group IB of the periodic table of elements and especially nickel, silver, gold, platinum, and/or copper. Examples of other topological insulators include BiₓSb₁₋ₓ, Bi₂Se₃, Bi₂Te₂Se, Bi₄Br₄, beta-Ag₂Te, GeBi₂Te₄, and WC.

Examples of non-crystalline topological quantum nanoparticles include topological insulators having washer, bipyramidal, biconic, or bispiral conic shapes that exhibit a chiral spin current flow.

As used herein, an "electrical connection" to a qubit may be a direct contact via a conducting lead or an indirect connection via a conducting lead positioned in close proximity to the qubit such that a functional electromagnetic connection is formed in which a current or a potential can be conducted between the qubit and the conducting lead. Examples of non-contacting connections include capacitive and inductive connections.

### Topological Quantum Nanoparticles:

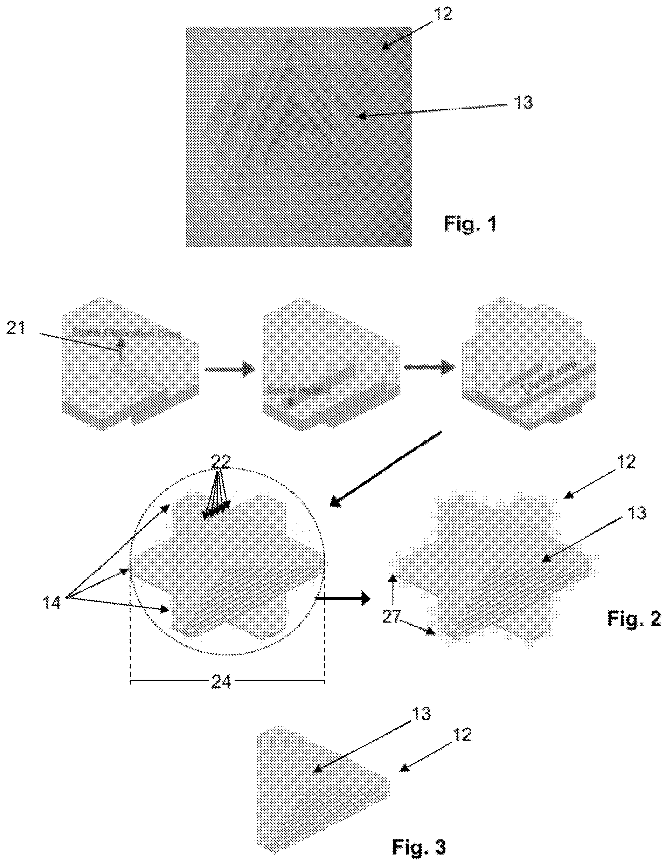

Topological quantum nanoparticles (TQNs) (11), such as those described herein, may have different three-dimensional shapes and topologies. One type of TQN (11) comprises a transition metal dichalcogenide (TMD) having a bipyramidal shape. Fig. 1 is a top view electron micrograph of a chiral, self-assembled, topological Sb₂Te₃ dichalcogenide anoplatelet/nanoparticle (12) in which a triangular spiral structure is visible on the top face (13) of the TMD nanoplatelet (12). Edges (14) of the bottom face (15) are visible around the edges (15) of the top face (13).

Fig. 2 illustrates sequential formation of a TMD nanoplatelet (12) of the type shown in Fig. 1. WO 2018/190919 A9 describes self-assembled TMD nanoparticles and their synthesis. A crystal lattice forms around a central axis (arrow, 21) (Fig. 2) with sequential layers (22) growing in opposite directions with opposite chiralities, with clockwise and counter clockwise turns, or convolutions moving axially from the center along the central axis (21) upwards and downwards, respectively. The top face (13) and the bottom face (15) have spiral topologies with the same chirality from the top end (23) of the top face (13) to the bottom end (25) of the bottom face (15). The diameter (24), or maximum width of the nanoplatelet, is normally at least five times greater than the height of the nanoplatelet in the direction along the central axis of the spirals. Axially, at or near the center of the TMD nanoplatelet (12) habit plane (26) separates the top and bottom halves of the TMD nanoplatelet (12).

TMD nanoplatelets (12) prepared by crystallization from solution have flat bipyramid structures and their spin currents can be enhanced by doping, or decorating, their habit plane (26) edges (14) with metal nanoparticles (27) as shown in Fig. 2. Additionally or alternatively, the energy difference between bistable points may be adjusted with doping by filling the topological states with an abundance of one type of electron carrier or another to optimize decoherence times at different temperatures.

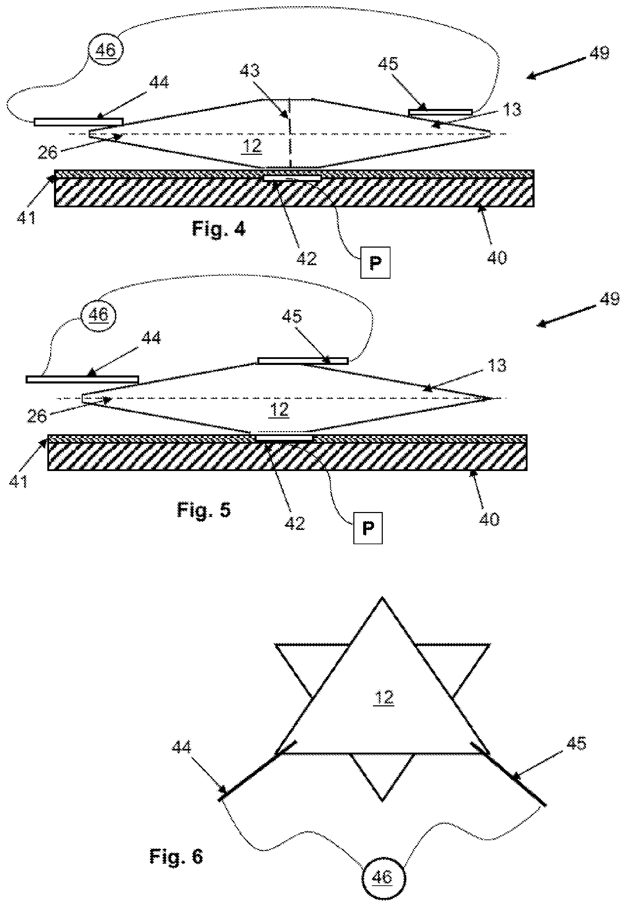

Not wishing to be bound by theory, it is believed that the complex topology of the nanoplatelet results in unexpected conduction channels with properties not reflected in the basic band structure of the nanoplatelet. Topological current flow for bipyramidal TMD nanoplatelet (12) TQNs (11) run along the spiral of the top face (13) from the habit plane (26) to the top and back along the central dislocation (Fig. 4). This current does not cross the habit plane (26) onto the bottom face (15), it is believed, because this would break charge-parity symmetry. The topological states are charge parity invariant so mirror currents are established in the two halves. While the object is electrically neutral, one current direction dominates for any given measurement, so that any measurement of current along the outside edges (14) will give a clockwise or counterclockwise current following the spiral.

A TMD nanoplatelet (12) having a pyramidal shape (Fig. 3) comprises a base plane (31) rather than a habit plane (26) and may be formed by initiation of crystal growth on a substrate by placing a solution capable of forming TMD nanoplatelets (12) onto the substrate and selectively heating spots on the substrate to initiate crystallization. TMD nanoplatelets (12) and other types of TQNs may be formed on a substrate by electrodeposition techniques. Pyramidally shaped TMD nanoplatelets (12) grown on a solid substrate rather than in solution exhibit spin current flow moving either up away from, or down toward, the base plane. As with the bipyramidal shaped nanoplatelets, a central dislocation allows the circuit of current to be complete by allowing the spin current to move either down toward, or up and away from, the base plane. Other examples of TQN shapes include mobius strips and other non-orientable surfaces made of topological insulators.

### Topological Quantum Nanoparticle Production:

Example 1: Antimony Telluride (Sb₂Te₃) topological quantum nanoparticles Antimony chloride (1.4 g) and tellurium oxide (1.44 g) are combined in 70 ml ethylene glycol under vacuum and mixed until a white solution forms. Sodium hydroxide (1.46 g) is added to the solution and dissolved. 0.8 g PVP is mixed into the solution and the solution is purged with argon gas. The solution is heated to between 125 and 135 °C, 8 ml hydrazine is added dropwise, the reaction proceeds 2-4 hours, the temperature is raised to 160°C and maintained for 12-18 hours, and then allowed to cool to 40°C. Precipitate is isolated by centrifugation and washing with acetone and ethanol and resuspended in ethanol with sonication before filtration over 0.1 micron filter. Additionally or alternatively, the precipitate may be washed with water and/or resuspended in water before filtration to improve stability during storage. Washing or storing the precipitate in water, however, may interfere with decorating (doping) the nanocrystals with metal nanoparticles.

### Example 2: Bismuth Telluride (Bi₂Te₃) topological quantum nanoparticles

Bismuth Nitrate Pentahydrate (6 mmol) and Sodium Tellurite (9 mmol) are combined in 70 ml ethylene glycol under vacuum and mixed until a white solution forms. Sodium hydroxide (1.46 g) is added to the solution and dissolved. 0.8 g PVP is mixed into the solution and the solution is purged with argon gas. The solution is heated to 180 °C for 12-18 hours, and then allowed to cool to 40°C. Precipitate is isolated by centrifugation and washing with acetone and ethanol and resuspended in ethanol with sonication before filtration on 0.1 micron filter.

### Example 3: Doping with Silver

Bismuth Telluride or Antimony Telluride quantum nanoparticles are suspended in 20 mL ethylene glycol and vortexed for 10-20 seconds and sonicated for 5-10 minutes. The resulting suspension is exposed to vacuum and stirred while head space is filled with argon gas. 0.4 g Silver Nitrate is added with mixing at room temperature and the reaction is allowed to proceed for 1 to 20 hours. The resulting solution is transferred to a centrifuge tube and 50 ml acetone is added before centrifugation at 5,000 RPM for 15 minutes. The liquid is decanted and the precipitate is washed in ethanol by vortexing, sonication, centrifugation, and decanting the liquid. The washed precipitate is resuspended in 20 ml ethanol and 40 ml water and filtered on a 0.1 micrometer filter. Additionally or alternatively, the precipitate may be washed with water and/or resuspended in water before filtration to improve stability during storage. Washing or storing the precipitate in water, however, may interfere with decorating (doping) the nanocrystals with metal nanoparticles.

### Example 4: Doping with Copper

Bismuth Telluride or Antimony Telluride quantum nanoparticles are suspended in 20 mL ethylene glycol and vortexed for 10-20 seconds and sonicated for 5-10 minutes. The resulting suspension is exposed to vacuum and stirred while head space is filled with argon gas. 0.4 g Copper Chloride is added with mixing at 70 °C and the reaction is allowed to proceed for 1 to 20 hours. The resulting solution is transferred to a centrifuge tube and 50 ml acetone is added before centrifugation at 5,000 RPM for 15 minutes. The liquid is decanted and the precipitate is washed in ethanol by vortexing, sonication, centrifugation, and decanting the liquid. The washed precipitate is resuspended in 20 ml ethanol and 40 ml water and filtered on a 0.1 micrometer filter.

### Example 5: Doping with Iron

Bismuth Telluride or Antimony Telluride quantum nanoparticles are suspended in 20 mL ethylene glycol and vortexed for 10-20 seconds and sonicated for 5-10 minutes. The resulting suspension is exposed to vacuum and stirred while head space is filled with argon gas. 0.4 g mmol Iron Chloride is added with mixing and the reaction is allowed to proceed for 1 to 15 hours. The resulting solution is transferred to a centrifuge tube and 50 ml acetone is added before centrifugation at 5,000 RPM for 15 minutes. The liquid is decanted and the precipitate is washed in ethanol by vortexing, sonication, centrifugation, and decanting the liquid. The washed precipitate is resuspended in 20 ml ethanol and 40 ml water and filtered on a 0.1 micrometer filter.

### Example 5: Doping with Nickel

Bismuth Telluride or Antimony Telluride quantum nanoparticles are suspended in 20 mL ethylene glycol and vortexed for 10-20 seconds and sonicated for 5-10 minutes. The resulting suspension is exposed to vacuum and stirred while head space is filled with argon gas. 0.4 g mmol Nickel Chloride is added with mixing and the reaction is allowed to proceed for 1 to 15 hours. The resulting solution is transferred to a centrifuge tube and 50 ml acetone is added before centrifugation at 5,000 RPM for 15 minutes. The liquid is decanted and the precipitate is washed in ethanol by vortexing, sonication, centrifugation, and decanting the liquid. The washed precipitate is resuspended in 20 ml ethanol and 40 ml water and filtered on a 0.1 micrometer filter.

### Topological Quantum Nanoparticle Qubit and Qubit Registers:

**Fig. 4** is a side cross-sectional view of components of one embodiment of a TQN-based qubit (49). In this embodiment, a TMD nanoplatelet is (12) oriented on a silicon wafer substrate (40) such that the habit plane (26) is mainly parallel to a surface electrically insulating layer (41) having a thickness of at least 3Å. Examples of suitable electrical insulators include silicon dioxide, sapphire, and alumina. The TMD nanoplatelet (12) may be, for example, an Sb₂Te₃ or Bi₂Te₃ TMD doped with copper or silver with a diameter of from about 1 µm to about 20 µm and with a height of less than about 200 nm. The TMD nanoplatelet (12) is positioned above a back gate (or bottom gate) lead (42) electrically connected to a power source (P), which can be used to pulse the TMD nanoplatelet (12) with an electrical potential of between 0.2 V and 1.0 V for a period of 0.1 µsec to 1 msec as a means for placing the TMD nanoplatelet (12) into a state of superposition in which the flow of current around the edge (14) of the habit plane (26) may be both clockwise and counterclockwise and the flow of current through the central dislocation (43) of the habit plane (26) may be a superposition of up and down. The back gate lead (42) may physically contact the bottom face (15) of the TMD nanoplatelet (12) or be close enough to the TMD nanoplatelet to transmit a current and potential across a small gap or thin section of silicon dioxide between the lead and the TMD nanoplatelet.

**Fig. 4** shows an embodiment in which the back gate lead (42) is not in direct contact with the bottom face (15) of the nanoplatelet (12). The back gate lead (42) may be positioned as shown or in direct contact with the bottom face (15) of the nanoplatelet (12). A first top lead (44) is in contact with, or in close proximity to, the top face (13) of the TMD nanoplatelet (12) near the edge (14) of the habit plane (26). In this example, a second top lead (45) is in contact with, or in close proximity to, the top face (13) of the TMD nanoplatelet (12) at a location that is on an opposite side of the top face (13) from the first top lead (44). The second top lead (45) need not be positioned on the opposite side of the top face (13) from the first top lead (44) and may be positioned at a distance from the first top lead (44) sufficient for a current or voltage to be detected between the two leads (44,45), such as at an angle of 120° with respect to the top end (23) of the nanoplatelet (12) (**Fig. 6**). The measured potential difference between the first and second leads (44,45) indicates the direction and magnitude of the current flowing in the TMD nanoplatelet (12).

**Fig. 5** is a side cross-sectional view showing a layout of components of another embodiment of a TQN-based qubit (49). In this embodiment, a TMD nanoplatelet is (12) oriented as in **Fig. 4****.** The back gate lead (42) in this embodiment is shown as in physical contact with the bottom face (15) of the TMD nanoplatelet (12) but the back gate lead (42) may alternatively be close enough to the TMD nanoplatelet to transmit a current and potential across a small gap or thin section of silicon dioxide between the lead and the TMD nanoplatelet. A first top lead (44) is in contact with, or in close proximity to, the top face (13) of the TMD nanoplatelet (12) near the edge (14) of the habit plane (26). In this example, a second top lead (45) is in contact with the top end (23), or in close proximity to, the top end (23) of the TMD nanoplatelet (12). The measured potential difference between the first and second leads (44,45) indicates the direction and magnitude of the current flowing in the TMD nanoplatelet (12).

The state measuring means (46) may be based on voltage measuring means, current measuring means, capacitance measuring means, and magnetic field measuring means. One advantage of TMD nanoplate topological quantum qubits (49) over other quantum computing technologies is a longer coherence time, or the length of time that a qubit can maintain a state of superposition. Coherence measurements of individual topological quantum qubits (49) comprising TMD nanoplatelets (12) indicate that topological quantum qubits have coherence time of from 10 ms to at least 10 s. These coherence times allow ample time for the quantum states of topological qubits (49) to be determined simultaneously after they have been placed into a quantum state of superposition.

### Voltage Measuring Means for Qubit State:

Referring to **Fig. 4****,** the first lead (44) and the second lead (45) are electrically connected to the TMD nanoplatelet (12) on the same side of the habit plane (26), which may be the top face (13) as shown, but may alternatively be the bottom face (15). The first and second leads (44,45) are positioned such that they are separated on the nanoplatelet by at least 10% of the diameter (24) of the nanoplatelet (12) and are connected to a means for measuring voltage. The measured potential difference between the first and second leads (44,45) indicates the direction and magnitude of the current flowing in the TMD nanoplatelet (12). For TMD nanoplatelet qubits (49), the measured voltage is on the order of microvolts, which is readily measured using existing volt meters. The voltage measurement may be a direct measurement of the potential between the first and second leads (44,45). Alternatively, an alternating potential may be applied a to the leads and a change in phase of the applied potential may be used to detect the direction of current in the qubit (49). For the embodiment shown in **Fig. 5****,** as with the embodiment shown in **Fig. 4****,** the measured potential difference between the first and second leads (44,45) indicates the direction and magnitude of the current flowing in the TMD nanoplatelet (12).

### Current Measuring Means for Qubit State:

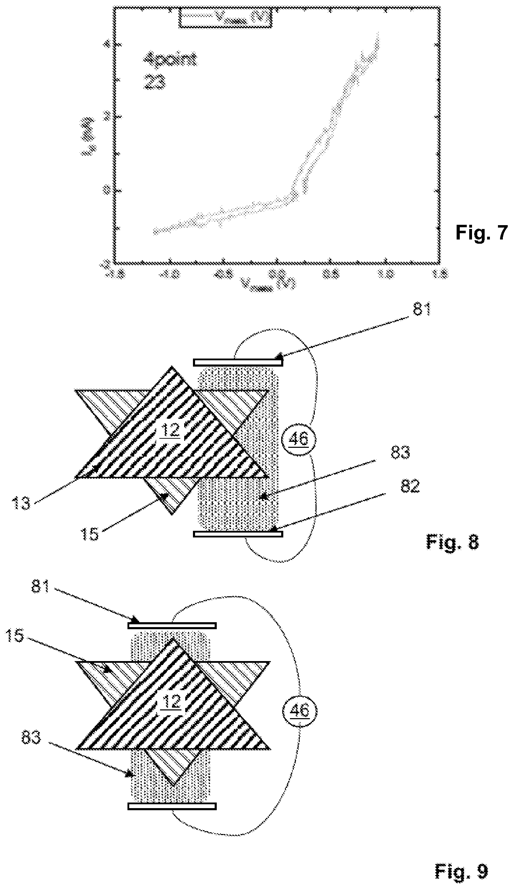

Referring to **Fig. 4****,** the first lead (44) and the second lead (45) are electrically connected to the TMD nanoplatelet (12) on the same side of the habit plane (26), which may be the top face (13) as shown, but may alternatively be the bottom face (15), in which case the leads are bottom face leads. The first and second leads top face (44,45) are positioned such that they are separated on the nanoplatelet by at least 10% of the diameter (24) of the nanoplatelet (12) and are connected to a means for measuring current such as a complementary metal-oxide-semiconductor (CMOS). The current measured between the first and second top face leads (44,45) indicates the direction and magnitude of the current flowing in the TMD nanoplatelet (12). The current may be measured directly or a very low input alternating current on the order of nano amps and millivolts may be delivered through the first top face lead (44) with the current coming from the second top face lead (45) measured. A change in slope for amperage vs. voltage is used to detect the direction of current in the qubit (49) (**Fig. 7**). The determination of state is based on the change in slope of the line in **Fig.** 7 as the current changes direction because the measured current is increased in the direction of current flow on the TMD nanoplatelet (12) and decreased in the direction of current flow opposite to that of the current flow on the TMD nanoplatelet (12).

The minimum current required to measure voltage depends on the sensitivity of the measuring device. The presence of silver nanoparticles or other nanoparticle dopants such as gold, platinum, copper, nickel and other Group IVA-VIIIA and Group IB metals may be used to form metallic nanoparticles bonded to the edges of the habit plane and establishing a metal semiconductor junction that may be used to increase electron density as needed to provide reliable measurable voltages. For any given qubit design, one may make a Hall measurement to determine detectable levels of current using a pico ammeter and adjust the presence or absence or type or amount of dopant as needed to achieve detectable levels of current.

A first embodiment of a qubit (49) comprising capacitance qubit state measuring means (46) is illustrated in **Fig. 8****.** A first end (81) of a capacitor (80) is positioned on the substrate (40) or insulating layer (41) on one lateral side of the bottom face (15) of the TMD nanoplatelet (12). A second, opposite end (82) of the capacitor (80) is positioned on the substrate (40) or insulating layer (41) on the opposite side of the bottom face (15) of the TMD nanoplatelet (12). A time varying voltage is applied into the first end (81) of the capacitor (80) and a time varying voltage is measured out from the second end (82) of the capacitor (80). The electric field caused by the spin electron current of the qubit (49) will cause a phase shift between the applied and measured voltages with the magnitude of the phase shift indicating which direction the current is flowing in the TMD nanoplatelet (12). The first and second ends (81,82) of the capacitor (80) are preferably positioned off center with respect to the TMD nanoplatelet (12) as shown in **Fig. 8** but they may alternatively be positioned centrally with respect to the TMD nanoplatelet (12) as shown in **Fig. 9****.** For embodiments as shown in **Figs. 8 and 9**, the first and second ends (81,82) of the capacitor (80) may be positioned on opposite sides of the top face (13) of the TMD nanoplatelet (12) instead of the bottom face (15) of the TMD nanoplatelet (12).

An electrolyte (83) may be placed between the first and second ends (81,82) of the capacitor (80) and in contact with the TMD nanoplatelet (12) so that voltage and current may be measured at the second end (82) of the capacitor (80) (**Fig**. **12**) with the phase shift of the current and/or voltage identifying the state of the TMD nanoplatelet (12).

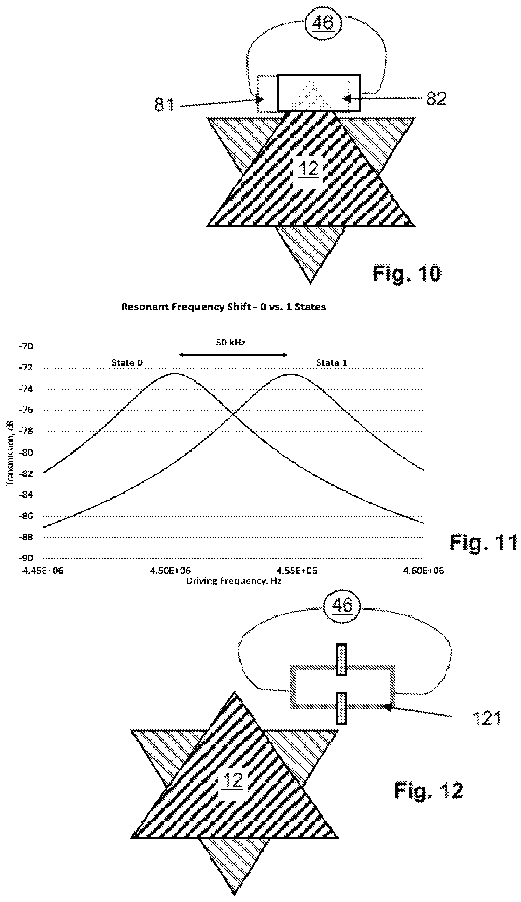

Another capacitance measuring configuration for a qubit (49) is illustrated in **Fig. 10****.** A first end (81) of a capacitor (80) is positioned on the substrate (40) or an insulator layer (41) on the substrate below the TMD nanoplatelet (12). An insulator (dielectric) layer is placed on the first end (81) of a capacitor, preferably before the TMD nanoplatelet (12) is placed on the substrate (40). An insulator layer is applied to the top side of the TMD nanoplatelet (12) above the first end (81) of a capacitor. A second end (82) of the capacitor (80) is positioned above the insulator on the top half of the TMD nanoplatelet (12). A time varying voltage is applied into the first end (81) of the capacitor and a time varying voltage is measured out from the second end (82) of the capacitor. The electric field of the qubit will cause a phase shift between the applied and measured voltages with the magnitude of the phase shift indicating which direction the current is flowing in the TMD nanoplatelet (12). **Fig. 11** illustrates an example of a result of capacitance measurements in which a measured curve for state 0 is distinguishable from a measured curve for state 1. In this case, state 0 and state 1 differ in the direction of current flow on the TMD nanoparticle.

A SQUID measuring means for determining the state (46) of the TMD nanoplatelet (12) is illustrated in **Fig. 12****.** The SQUID loop (121) is positioned in close proximity to the TMD nanoplatelet (12) to measure the magnetic field in and near the SQUID loop (121), which indicates the direction of current flow in the TMD nanoplatelet (12). A disadvantage of this means for determining the state (46) of the TMD nanoplatelet (12) is that cryogenic temperatures are required for the measurement, while the qubit is operational at room temperature. Cryogenic temperatures, however, may greatly extend the coherence times of the qubit for certain applications.

### Entanglement of Qubits:

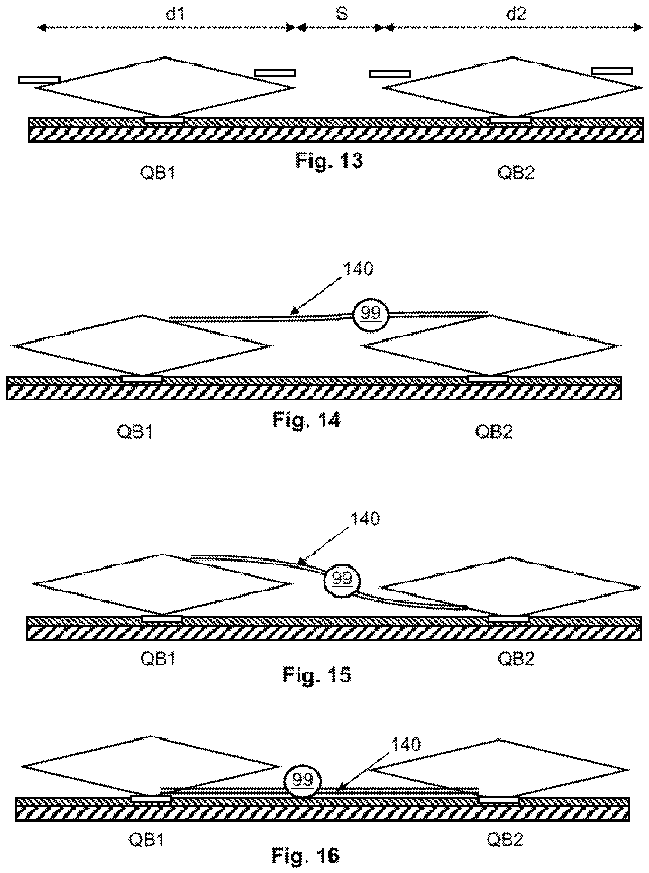

TQN-based qubits can be entangled by proximity, electrical connection, and selectable electrical connection. **Fig. 13** illustrates one example of entangling two qubits (49) by proximity. A first TMD-based qubit (QB1) having a diameter (d1) may be entangled with a second qubit (QB2) having a dimeter (d2) with the first and second qubits being separated by a distance S. The distance S is small enough for the electric or magnetic fields associated with the spin currents to influence one another. For an average diameter (AD) of the first and second qubits (d1+d2)/2, S is preferably in a range of from 0.01AD to 1.0AD, or from 0.01 µm to 5.0 µm for AD ranging from 1 µm to 5 µm. The optimal spacing may vary depending on the composition and size of the topological qubits (49). Entangled topological qubits (49) oriented side by side in the same plane have opposite directions of spin current. Topological qubits (49) oriented top to bottom to be vertically entangled by proximity have the same directions of spin current.

TQN-based qubits can also be entangled by electrical connection using connecting leads (140) to electrically connect topological qubits (49) to one another. The interconnecting leads (140) are impedance matched. **Figs. 14-16** are side cross-sectional views of two qubits connected by a lead (140) comprising an optional solid state switch (99), such as a microtransistor, for selectively entangling or disentangling the two qubits (49). The qubits may be electrically connected top to top through a connecting lead (140), bottom to bottom through their back gate leads (42), or top to bottom or bottom to bottom through their back gate leads (42) and/or a connecting lead (140), optionally comprising a transistor or other solid state switch (99).

Connecting TMD nanoplatelet (12) qubits (49) top to top (**Fig. 14**) or bottom to bottom (**Fig. 16**) entangles them to have opposite directions of spin current and connecting qubits top to bottom (**Fig. 15**) or bottom to top entangles them to have the same directions of spin current. The connecting leads (140) are shown as being above the substrate (40) and insulating layer (41) but a connecting lead (140) may be on or in the substrate (40) or insulating layer (41) for a portion of all of its length. Back gate electrodes (42) may be connected by a conducting lead in, on, or under the substrate (40). A back gate in or on the substrate is convenient for pulsing a TQN but a back gate is not necessary if another electrical lead is used to pulse the TQN, such as a top electrode placed in contact with, or in close proximity to, the top of the TQN.

Solid state switches (99) may be incorporated into the connecting leads (140) to allow qubits (49) to be selectively entangled or disconnected. The connecting leads may extend to a location remote from the substrate (40), for example to a conventional computer or microprocessor for controlling the switches (99). It is also possible to arrange an array of qubits with some of the qubits entangled by proximity, some entangled by electrical connection, and some qubits entangled with a plurality of qubits by proximity and/or electrical connections. Solid state switches (99) suitable for use with electrical connecting leads (140), including micro transistors, are commercially available.

### Topological Quantum Nanoparticle Registers:

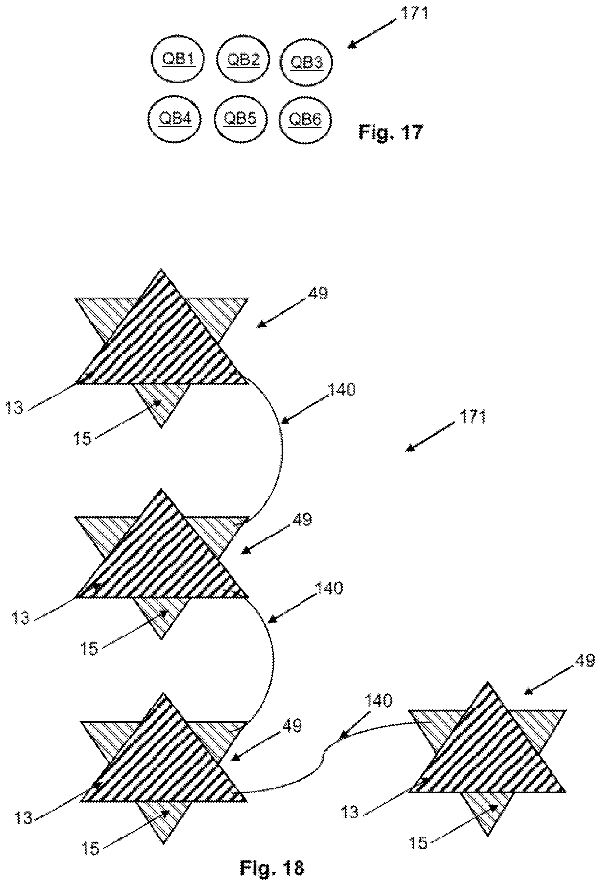

A topological qubit register (171) comprises at least two entangleable topological qubits (49) arranged on a substrate (40) with each qubit electrically connected to a bottom, or back gate (42), comprising an electrical conductor. The back gate (42) may be configured as an discrete structure or it may be an exposed portion of a larger electrode that forms a plurality of back gates (42). **Fig. 17** is a schematic top view of one embodiment of a TQN-based register (171) comprising an array of six topological qubits (49, QB-QB6) entangled by proximity. QB 1 is entangled with QB2 and QB4, QB2 is entangled with QB1, QB3, and QB5. QB3 is entangled with QB2 and QB6. QB4 is entangled with QB1 and QB5. QB5 is entangled with QB2, QB4, and QB6. QB 6 is entangled with QB3 and QB5. Since all of the qubits (49) are arranged side-by-side, their entanglement is such that each qubit (49) has an opposite direction of spin current from each neighboring qubit. Specific types of logic gates can be generated by the placement of qubits in different relative spatial positions (e.g. side to side and/or top to bottom) to provide any desired entanglement patterns.

**Fig. 18** is a top view schematic of a TQN-based register (171) comprising a series array of four TMD-based qubits (49) electrically entangled top to bottom. The qubits (49) are electrically connected in series by conducting leads (140), which may run along the top of the substrate, inside the substrate, below the substrate, and/or combinations of these. In alternative embodiments, any number of qubits (49) may all be connected top to top or in any combination of top to top, top to bottom, and bottom to top. Additionally or alternatively, any one of the qubits may be electrically connected to and entangled with more than one of the other qubits. Any number or combination of conducting leads may comprise a solid state switch (99).

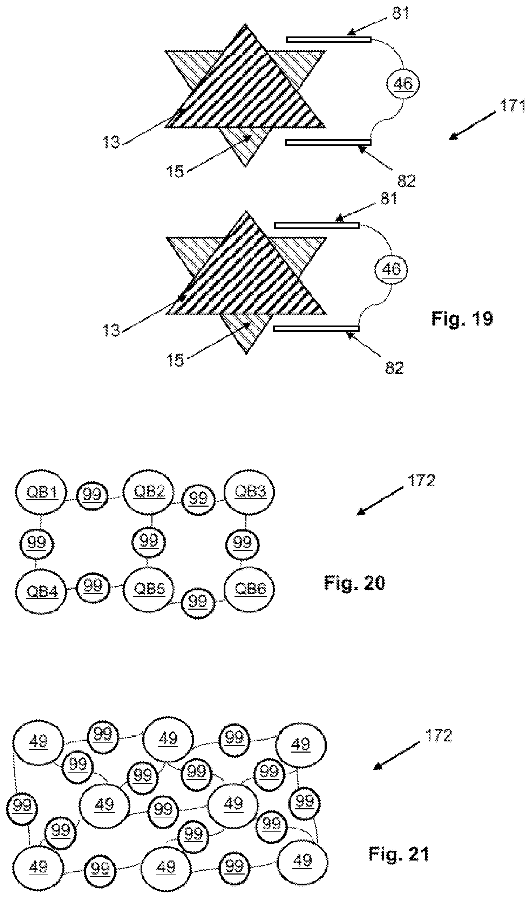

**Fig. 19** is a top view schematic of a register (171) comprising two TMD-based topological qubits (49) and capacitance measuring means (46) to illustrate one example configuration for simultaneously determining the quantum current states of both topological qubits (49). The topological qubits (49) may be connected top to top or top to bottom. Additionally or alternatively, the two qubits may be electrically connected to separate back gate leads or a common back gate lead. Having the qubits electrically connected to a common back gate lead simplifies the process of pulsing both qubits at the same time to set them into superposition states. This applies to arrays of qubits as well as portions of arrays of qubits (49).

**Fig. 20** is a top view schematic of an array (172) comprising six topological qubits (49) entangled with seven selectively switchable connecting leads. QB1 can be selectively entangled with QB2 and/or QB4, QB2 can be selectively entangled with QB1, QB3, and/or QB5. QB3 can be selectively entangled with QB2 and/or QB6. QB4 can be selectively entangled with QB1 and/or QB5. QB5 can be selectively entangled with QB2, QB4, and/or QB6. QB6 can be selectively entangled with QB3 and/or QB5. The switch containing connecting leads (140) may be configured to connect any pair of qubits top to top or top to bottom to allow the configuration of different types of logic gates using the same array of topological qubits (49). Solid state switches (99) may be incorporated into any array of qubits to allow the gating to be reconfigured by opening or closing them to change connection patterns to form differently configured registers and/or gates.

**Fig. 21** is top view schematic of an embodiment of an array of eight topological qubits (49) connected by fourteen connecting leads (140) comprising selectively switchable solid state switches (99). As can be seen in the figures, arrays of topological qubits may have any number of spatial arrangements or configurations, including square, rectangular, triangular, and diamond arrays making it possible to create a wide variety and number of gates and registers using the same array (172). Using switchable more than one switchable connecting lead (140) between pairs of topological qubits (49), or a combination of a switchable connecting lead (140) and a switchable back gate electrode (42), it is possible to change the entanglement between pairs of topological qubits (49) between top to top, top to bottom, bottom to top, and/or bottom to bottom.

### Topological Quantum Circuits:

A topological quantum circuit may be constructed by forming a sequence of topological quantum gates. One advantage of constructing an array (172) of topological qubits (49) connected by connecting leads (140) comprising selectively switchable solid state switches (99) is that the solid state switches may be used to generate different topological quantum circuits from the same array of static topological qubits.

### Topological Quantum Nanoparticle Qubit and Register Production:

A qubit and qubit registers can be made using preformed TQNs using several methods. Qubits may be made by forming a gate electrode on a nonconducting substrate, forming an insulating layer over the gate, anchoring a semiconductor nanoparticle crystal onto the insulating layer in contact with or in apposition to the gate electrode, and placing electrodes on or in apposition to the top half of the crystal.

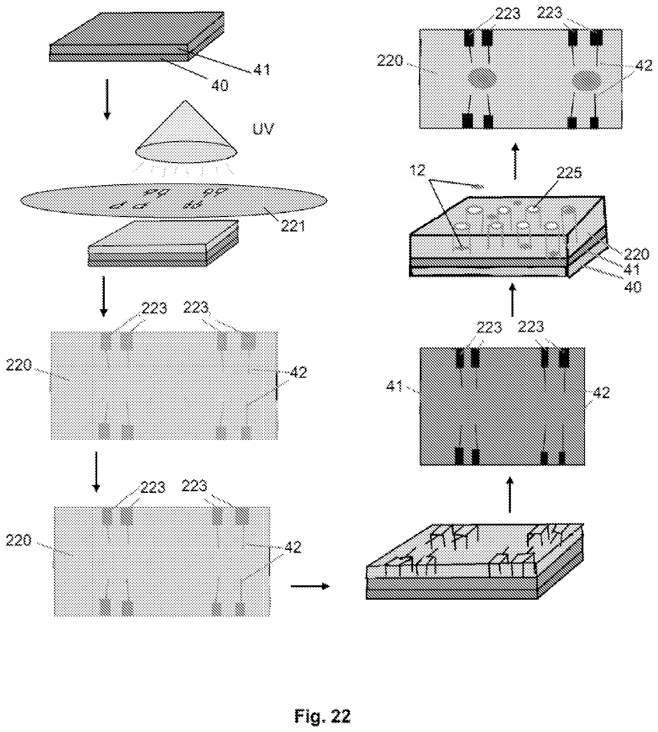

**Fig. 22** is a pictogram illustrating one embodiment of a lithographic method for making a TQN register (171). A substrate (40) comprising a silicon wafer with a surface layer of silicon dioxide insulator (41) is covered with a photoresist (220) and a mask (221) outlining the positions of back gate leads (42) to which TMD nanoplatelets (12) will be electrically connected and the mask is exposed to UV light (UV). The mask (221) is removed and the photoresist (220) is developed to expose silicon (40) where the back gate leads (42) and contacts (223) are desired. Vapor deposition is used to deposit an electrical conductor such as aluminum or gold on the exposed silicon to make the back gate leads (42) and contacts (223) and the remaining photoresist is removed. A new layer of photoresist (220) is applied and covered with a mask having holes where the TMD nanoplatelets (12) are to be positioned over the back gate leads (42). The holes are approximately the diameter of the TMD nanoplatelets to be used (e.g. 2-3 microns). The mask is exposed to UV light and removed. The photoresist is developed to form wells (225) in the photoresist (220) where it was exposed to UV light. A dilute suspension of TMD nanoplatelets (12) is deposited onto the surface of the photoresist and an electrical potential is applied across the substrate and photoresist to cause the TMD nanoplatelets (12) to migrate into the wells above the back gate leads (42). The electric potential may be applied in the form of a matrix or array of spot potentials corresponding to the positions of the wells in the second photoresist. The suspension of TMD nanoplatelets (12) is preferably sieved so that the suspension contains nanoplatelets of a consistent size corresponding to the size of the holes made in the second photoresist. Sieving may be achieved by electrophoresis or size exclusion chromatography, for example. The second photoresist may be removed before connecting leads (140) connecting to the top faces (13) of the TMD nanoplatelets (12) are made using standard e-beam lithography.

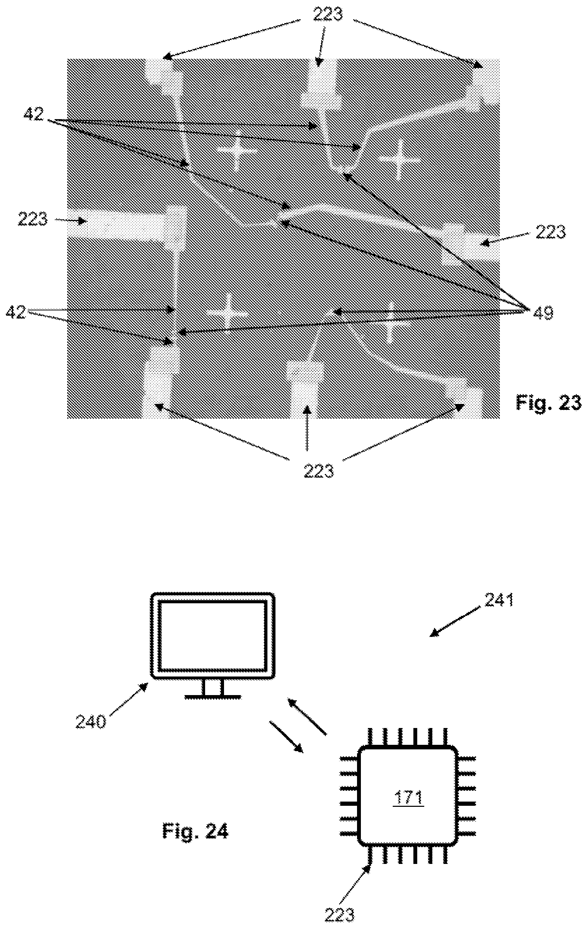

**Fig. 23** is a top view photograph of one embodiment of an array (172) of four topological qubits (49) on a silicon wafer (or chip) substrate with a silicon dioxide insulating layer forming a four qubit register (171). Contacts (223) and leads (42) were made using standard e-beam lithography such that the leads (42) are electrically connected to the top faces (13) of TMD nanoplatelets (12) that are positioned over back gate electrodes (not visible). The contacts (223) extend a small distance beyond the edge of the photograph and wafer for further electrical connection to a computer comprising software that controls a power supply for setting the qubits into a state of superposition and for simultaneously measuring the quantum states of the four qubits (49) simultaneously. For embodiments of a qubit array (172) comprising switchable leads, the computer additionally comprises software for controlling solid state switches. The computer may comprise software configured for testing each individual qubit (49) for being functional for being placed into a state of superposition and for entanglement with other qubits as well as isolating nonfunctional qubits from the rest of the qubits in the array.

### Topological Quantum Nanoparticle Computer:

A TQN computer, or topological quantum computer (241) may comprise a classical computing device (240) interfacing with at least one TQB-based register (171). The computing device provides sets of instructions executed by convention circuitry to communicate with, control, and receive information from the quantum register (171). The computing device (240) sets TQN-based qubits (49) to desired states, for example by setting a superposition state or a state with one direction of current flow or another by controlling a potential applied to the back gate electrodes (42). The computing device (240) communicates with means for measuring quantum states (46) of the qubits (49). The computing means may comprise means for measuring quantum states (46) that are electrically connected to contacts on the topological quantum register (171).

Advantages of TQN-based quantum registers (171) include their ability to operate at temperatures compatible with standard digital computers and that they can be manufactured using methods and materials compatible with those for making digital computers. For example, a topological quantum register operates at temperatures greater than 7K to 233K and up to 500K, with lower temperatures providing advantages of longer coherence times, although coherence times at 233K and even 500K are sufficient for quantum computing. This means that it is possible integrate one or more TQN-based quantum registers (171) into a conventional digital computer (240) in which the one or more quantum registers (171) is incorporated into the circuitry of the digital computer. It is also possible to construct a universal topological quantum computer comprising a complete set of topological qubit logic gates.

Operation of a topological quantum computer (241) may comprise the following operations:
using the digital computer (240), addressing each topological qubit (49);
using the digital computer (240), performing one or more functional tests to identify which topological qubits (49) are functioning properly and which are not;
using the digital computer (240), receiving input data through a user interface or from a program to determine which interconnections are made between topological qubits by controlling solid state switches;
using the digital computer (240), controlling solid state switches connecting topological qubits to form one or more topological quantum registers (171);
using the digital computer (240), controlling solid state switches connecting topological qubits to form one or more topological quantum gates;
using the digital computer (240), controlling solid state switches connecting topological qubits to form one or more topological quantum circuits;
using the digital computer (240), providing a timing circuit for sequential and simultaneous actions including setting topological qubits into superposition (254) and measuring states of collections of entangled topological qubits; and
using the topological quantum register(s), performing a quantum Fourier transform.

Some or all of the operations may be performed in a variety of sequences and many other operations are possible. Some of the operations are performed iteratively. For example, once the solid state switches have been set under the control of the digital computer, the qubits may be repeatedly set to superposition and measured.

## Claims

1. A topological quantum register comprising an array of topological qubits on a substrate, wherein each of said topological qubits comprises a topological quantum nanoparticle (12) electrically coupled to a pulsing lead (42),
said pulsing lead being configured to pulse said topological quantum nanoparticle with an electrical potential, and means for determining the states of said topological qubits simultaneously
wherein said topological quantum nanoparticle is a transition metal dichalcogenide (TMD) nanoplatelet having a topology that creates at least two degenerate charge parity protected quantum states exhibiting spin current flows and
wherein said means for determining the states of said topological qubits simultaneously comprises detecting a direction of spin current flows exhibited by each said TMD nanoplatelet.

2. The topological quantum register of claim 1, wherein said spin current flows of said topological qubits are entangled by proximity of said topological quantum qubits to one another.

3. The topological quantum register of claim 1, wherein said spin current flows of said topological qubits are entangled by connecting leads forming electrical connections between said topological qubits.

4. The topological quantum register of claim 3, wherein one or more of said electrical connections between said topological qubits comprises a solid state switch.

5. The topological quantum register of claim 4, further comprising an electrical connection between said solid state switch and a computer and wherein said solid state switch is controlled by said computer.

6. The topological quantum register of claim 1, wherein said means for determining the states of said topological qubits simultaneously is a voltammetric means, a current measuring means, a capacitance means, an inductance means, a polarization detecting means, or a SQUID means.

7. The topological quantum register of claim 5, wherein said computer controls said means for determining quantum states of said quantum bits simultaneously and said pulsing lead.

8. The topological quantum register of claim 5, wherein said solid state switch is operable to be controlled by said computer when said solid state switch is at a temperature greater than 70 K.

9. A method for making a quantum register comprising an array of qubits, said method comprising:
providing a substrate comprising an array of back gate electrodes;
positioning a topological quantum nanoparticle (12) in contact with or in apposition to each of a plurality of said back gate electrodes so as to electrically connect said topological quantum nanoparticles to said plurality of said back gate electrodes;
depositing electrically conducting leads (42) onto the substrate in relation to said topological quantum nanoparticles to form a means for determining quantum states of said topological quantum nanoparticles simultaneously
wherein said topological quantum nanoparticle is a transition metal dichalcogenide (TMD) nanoplatelet having a topology that creates at least two degenerate charge parity protected quantum states exhibiting spin current flows and
wherein said means for determining the states of said topological qubits simultaneously comprises detecting a direction of spin current flows exhibited by each said TMD nanoplatelet.

10. The method of claim 9, wherein said back gate electrodes are embodied as a single electrode partially covered by an electrical insulator to expose said array of back gate electrodes.

11. The method of claim 9, wherein said substrate comprises a silicon wafer having a surface layer of an electrical insulator.

12. The method of claim 11, and further comprising:
covering said substrate and back gate electrodes with a resist layer or photoresist layer, and forming a hole pattern in the resist or photoresist layer above said back gate electrodes using photolithography
wherein said positioning a topological quantum nanoparticle comprises placing a conductive electrode in contact with a suspension of topological quantum nanoparticles on said substrate and
applying a bias voltage between the conductive electrode and the back gate electrodes to guide said topological quantum nanoparticles toward the back gate electrodes.

13. The method of claim 9, and further comprising covering said substrate and back gate electrodes with an insulating layer and forming holes in the insulating layer above said back gate electrodes,
wherein said positioning a topological quantum nanoparticle comprises applying a suspension of topological quantum nanoparticles onto said substrate and applying a potential to said back gate electrodes to direct said topological quantum nanoparticle into one of said holes.

14. The method of claim 9, and further comprising individually testing the functionality of the qubits.

## Patentansprüche

1. Topologisches Quantenregister, das ein Array von topologischen Qubits auf einem Substrat umfasst, wobei jedes der topologischen Qubits ein topologisches Quantennanopartikel (12) umfasst, das mit einem pulsierenden Anschlusselement (42) elektrisch gekoppelt ist, wobei das pulsierende Anschlusselement konfiguriert ist, um das topologische Quantennanopartikel mit Pulsen eines elektrischen Potentials zu versorgen; und das ein Element zum gleichzeitigen Ermitteln der Zustände der topologischen Qubits umfasst,
wobei das topologische Quantennanopartikel ein Nanoplättchen aus einem Übergangsmetall-Dichalkogenid (TMD-Nanoplättchen) ist, das eine Topologie aufweist, die mindestens zwei degenerierte ladungsparitätsgeschützte Quantenzustände erzeugt, die Spinströme aufweisen, und
wobei das Element zum gleichzeitigen Ermitteln der Zustände der topologischen Qubits ein Erkennen einer Richtung der Spinströme umfasst, die von jedem TMD-Nanoplättchen präsentiert werden.

2. Topologisches Quantenregister nach Anspruch 1, wobei die Spinströme der topologischen Qubits, durch die Nähe der topologischen Quantenqubits zueinander, miteinander verflochten sind.

3. Topologisches Quantenregister nach Anspruch 1, wobei die Spinströme der topologischen Qubits miteinander verflochten werden, indem die Anschlusselemente verbunden werden, die elektrische Verbindungen zwischen den topologischen Qubits bilden.

4. Topologisches Quantenregister nach Anspruch 3, wobei eine oder mehrere der elektrischen Verbindungen zwischen den topologischen Qubits einen Festkörperschalter umfassen.

5. Topologisches Quantenregister nach Anspruch 4, das ferner eine elektrische Verbindung zwischen dem Festkörperschalter und einem Computer umfasst, und wobei der Festkörperschalter von dem Computer gesteuert wird.

6. Topologisches Quantenregister nach Anspruch 1, wobei das Element zum gleichzeitigen Ermitteln der Zustände der topologischen Qubits ein voltammetrisches Element, ein Strommesselement, ein Kapazitätselement, ein Induktivitätselement, ein Polarisationserkennungselement oder ein SQUID-Element ist.

7. Topologisches Quantenregister nach Anspruch 5, wobei der Computer das Element zum gleichzeitigen Ermitteln der Zustände der topologischen Qubits und das pulsierende Anschlusselement zu steuert.

8. Topologisches Quantenregister nach Anspruch 5, wobei der Festkörperschalter funktionsfähig ist, um von dem Computer gesteuert zu werden, wenn sich der Festkörperschalter bei einer Temperatur von mehr als 70 K befindet.

9. Verfahren zum Herstellen eines Quantenregisters, das ein Array von Qubits umfasst, wobei das Verfahren umfasst:
Bereitstellen eines Substrats, das ein Array von Back-Gate-Elektroden umfasst;
Positionieren eines topologischen Quantennanopartikels (12) in einen Kontakt mit oder in eine Anlagerung an jede aus der Vielzahl von Back-Gate-Elektroden, um die topologischen Quantennanopartikel mit der Vielzahl von Back-Gate-Elektroden elektrisch zu verbinden;
Abscheiden von elektrisch leitfähigen Anschlusselementen (42) auf dem Substrat in Bezug auf die topologischen Quantennanopartikel, um ein Element zum gleichzeitigen Ermitteln der Zustände der topologischen Qubits zu bilden,
wobei das topologische Quantennanopartikel ein Nanoplättchen aus einem Übergangsmetall-Dichalkogenid (TMD-Nanoplättchen) ist, das eine Topologie aufweist, die mindestens zwei degenerierte ladungsparitätsgeschützte Quantenzustände erzeugt, die Spinströme aufweisen, und
wobei das Element zum gleichzeitigen Ermitteln der Zustände der topologischen Qubits ein Erkennen einer Richtung der Spinströme umfasst, die von jedem TMD-Nanoplättchen präsentiert werden.

10. Verfahren nach Anspruch 9, wobei die Back-Gate-Elektroden als eine einzige Elektrode konkretisiert sind, die nur teilweise von einem elektrischen Isolator abgedeckt werden, um das Array von Back-Gate-Elektroden freizulegen.

11. Verfahren nach Anspruch 9, wobei das Substrat einen Siliciumwafer umfasst, der eine Oberflächenschicht aus einem elektrischen Isolator aufweist.

12. Verfahren nach Anspruch 11, und das ferner umfasst:
Abdecken des Substrats und der Back-Gate-Elektroden mit einer Schutzschicht oder einer Fotolackschicht und Bilden, unter Verwendung einer Fotolithografie, eines Lochmusters in der Schutzschicht oder der Fotolackschicht über den Back-Gate-Elektroden,
wobei das Positionieren eines topologischen Quantennanopartikels ein Platzieren einer leitfähigen Elektrode in einen Kontakt mit einer Suspension von topologischen Quantennanopartikeln auf dem Substrat umfasst; und
Anlegen einer Vorspannung zwischen die leitfähige Elektrode und die Back-Gate-Elektroden, um die topologischen Quantennanopartikel in Richtung auf die Back-Gate-Elektroden zu führen.

13. Verfahren nach Anspruch 9, und das ferner ein Abdecken des Substrats und der Back-Gate-Elektroden mit einer Isolationsschicht und ein Bilden von Löchern in der Isolationsschicht über den Back-Gate-Elektroden umfasst, wobei das Positionieren eines topologischen Quantennanopartikels ein Applizieren einer Suspension von topologischen Quantennanopartikeln auf das Substrat und ein Anlegen eines Potentials an die Back-Gate-Elektroden umfasst, um die topologischen Quantennanopartikel in eines der Löcher zu leiten.

14. Verfahren nach Anspruch 9, und das ferner ein individuelles Testen der Funktionalität der Qubits umfasst.

## Revendications

1. Registre quantique topologique comprenant un réseau de bits quantiques topologiques sur un substrat, où chacun desdits bits quantiques topologiques comprend une nanoparticule quantique topologique (12) couplée électriquement à un conducteur d'impulsion (42), ledit conducteur d'impulsion étant configuré pour pulser ladite nanoparticule quantique topologique avec un potentiel électrique, et des moyens pour déterminer les états desdits bits quantiques topologiques simultanément
où ladite nanoparticule quantique topologique est une nanoplaquette de dichalcogénure de métal de transition (TMD) ayant une topologie qui crée au moins deux états quantiques dégénérés, protégés par la parité de charge, et présentant des flux de courant de spin, et
où lesdits moyens pour déterminer les états desdits bits quantiques topologiques comprennent simultanément la détection d'une direction de flux de courant de spin présentés par chacune desdites nanoplaquettes TMD.

2. Registre quantique topologique selon la revendication 1, dans lequel lesdits flux de courant de spin desdits bits quantiques topologiques sont enchevêtrés par la proximité desdits bits quantiques topologiques les uns par rapport aux autres.

3. Registre quantique topologique selon la revendication 1, dans lequel lesdits flux de courant de spin desdits bits quantiques topologiques sont enchevêtrés par des conducteurs de connexion formant des connexions électriques entre lesdits bits quantiques topologiques.

4. Registre quantique topologique selon la revendication 3, dans lequel une ou plusieurs desdites connexions électriques entre lesdits bits quantiques topologiques comprennent un commutateur à semi-conducteurs.

5. Registre quantique topologique selon la revendication 4, comprenant en outre une connexion électrique entre ledit commutateur à semi-conducteurs et un ordinateur, et dans lequel ledit commutateur à semi-conducteurs est commandé par ledit ordinateur.

6. Registre quantique topologique selon la revendication 1, dans lequel lesdits moyens pour déterminer simultanément les états desdits bits quantiques topologiques sont des moyens voltamétriques, des moyens de mesure de courant, des moyens de capacité, des moyens d'inductance, des moyens de détection de polarisation ou des moyens SQUID.

7. Registre quantique topologique selon la revendication 5, dans lequel ledit ordinateur commande lesdits moyens pour déterminer les états quantiques desdits bits quantiques simultanément et dudit conducteur d'impulsion.

8. Registre quantique topologique selon la revendication 5, dans lequel ledit commutateur à semi-conducteurs peut fonctionner pour être commandé par ledit ordinateur lorsque ledit commutateur à semi-conducteurs est à une température supérieure à 70 K.

9. Procédé de fabrication d'un registre quantique comprenant un réseau de bits quantiques, ledit procédé comprenant les étapes suivantes :
fournir un substrat comprenant un réseau d'électrodes de grille arrière ;
positionner une nanoparticule quantique topologique (12) en contact ou en apposition avec chacune desdites électrodes de grille arrière de manière à connecter électriquement lesdites nanoparticules quantiques topologiques à ladite pluralité desdites électrodes de grille arrière ;
déposer des conducteurs électriques (42) sur le substrat en relation avec lesdites nanoparticules quantiques topologiques afin de former des moyens permettant de déterminer simultanément les états quantiques desdites nanoparticules quantiques topologiques,
où ladite nanoparticule quantique topologique est une nanoplaquette de dichalcogénure de métal de transition (TMD) ayant une topologie qui crée au moins deux états quantiques dégénérés, protégés par la parité de charge, et présentant des flux de courant de spin, et
où lesdits moyens pour déterminer les états desdits bits quantiques topologiques comprennent simultanément la détection d'une direction de flux de courant de spin présentés par chacune desdites nanoplaquettes TMD.

10. Procédé selon la revendication 9, dans lequel lesdites électrodes de grille arrière sont réalisées sous la forme d'une électrode unique partiellement recouverte par un isolant électrique pour exposer ledit réseau d'électrodes de grille arrière.

11. Procédé selon la revendication 9, dans lequel ledit substrat comprend une tranche de silicium ayant une couche de surface en isolant électrique.

12. Procédé selon la revendication 11, et comprenant en outre les étapes suivantes :
recouvrir ledit substrat et lesdites électrodes de grille arrière d'une couche de résine ou d'une couche de résine photosensible, et former un motif de trous dans la résine ou la couche de résine photosensible au-dessus desdites électrodes de grille arrière par photolithographie,
où ledit positionnement d'une nanoparticule quantique topologique comprend la mise en contact d'une électrode conductrice avec une suspension de nanoparticules quantiques topologiques sur ledit substrat, et
l'application d'une tension de polarisation entre l'électrode conductrice et les électrodes de grille arrière pour guider lesdites nanoparticules quantiques topologiques vers les électrodes de grille arrière.

13. Procédé selon la revendication 9, et comprenant en outre de recouvrir lesdits substrat et électrodes de grille arrière avec une couche isolante et de former des trous dans la couche isolante au-dessus desdites électrodes de grille arrière,
où ledit positionnement d'une nanoparticule quantique topologique comprend d'appliquer une suspension de nanoparticules quantiques topologiques sur ledit substrat et d'appliquer un potentiel auxdites électrodes de grille arrière pour diriger ladite nanoparticule quantique topologique dans l'un desdits trous.

14. Procédé selon la revendication 9, et comprenant en outre de tester individuellement la fonctionnalité des bits quantiques.
